# EUROPÄISCHE PATENTSCHRIFT

(11) **EP 2 975 707 B1**
(45) Veröffentlichungstag und Bekanntmachung des Hinweises auf die Patenterteilung: **16.11.2016**
(21) Anmeldenummer: 14177667.4
(22) Anmeldetag: 18.07.2014
(51) Int. Cl.: H02B 1/18, G01R 15/14, H02J 13/00, H01H 85/02

(54) **Einbauvorrichtung, System und Verfahren zur Regelung von Spannungsnetzen**
Built-in device, system and method for controlling voltage networks
Dispositif de montage, système et procédé de réglage de réseaux de tension

(43) Veröffentlichungstag der Anmeldung: 20.01.2016
(73) Patentinhaber: SAG GmbH, 44269 Dortmund (DE)
(72) Erfinder: Schneider, Rudi, 46 049 Oberhausen (DE); Scharnberg, Raoul, 44269 Dortmund (DE)
(74) Vertreter: Rohmann, Michael

(56) Entgegenhaltungen:
- EP-A2- 2 053 627
- EP-A2- 2 555 003
- EP-B1- 0 830 810
- DE-U1- 29 705 224
- FR-A1- 2 967 832

## Beschreibung

Die Erfindung betrifft eine Einbauvorrichtung zum Einbau in standardisierten Schaltgerüsten in Kabelverteilstationen von Spannungsnetzen.

Einbauvorrichtungen der eingangs genannten Art sind aus der Praxis in verschiedenen Ausführungsformen bekannt. Bei diesen Einbauvorrichtungen handelt es sich in der Regel um Sicherungslastschaltleisten, welche in herstellerübergreifend bemessenen Schaltgerüsten, beispielsweise in Kabelverteilerschränken an Straßenrändern, eingesetzt werden. Solche Einbauvorrichtungen befinden sich darüber hinaus in Schaltschränken von industriellen Anlagen sowie von Energieverteilungsanlagen. Von diesen Einbauvorrichtungen zweigen eine Reihe an elektrischen Verbrauchern ab. Dies sind beispielsweise Häuser eines Straßenabschnitts oder auch größere Maschinen einer Werkshalle. Die Häuser bzw. Maschinen werden im Sicherungsfall durch die Sicherungslastschaltleisten vom Spannungsnetz getrennt.

Dabei ist der Einsatz von Messtechnik in Sicherungslastschaltkreisen in Niederspannungsnetzen als solches grundsätzlich bekannt. In FR 2 967 832 A1 und in EP 2 555 003 A2 wird jeweils eine Einbauvorrichtung zum Einbau in standardisierten Schaltgerüsten in Kabelverteilstationen von Niederspannungsnetzen beschrieben. Die Einbauvorrichtung umfasst jeweils ein Reiterunterteil sowie Teilkomponenten in Form einer Kommunikationseinheit und eines Sensors.

Die Spannungsnetze und insbesondere die Niederspannungsnetze sind nahezu bis völlig intransparent. D.h., dass den Netzbetreibern die einzelnen lokalen Netzzustände, beispielsweise innerhalb eines Straßennetzes, nicht bekannt sind. Es fehlt schlicht an Mitteln, welche die Netzzustände lokal erfassen und an die Netzbetreiber weiterleiten. Dies war bis zum Einsatz volatiler Energien auch nicht weiter problematisch, da der Fluss der elektrischen Energie ausschließlich von den Kraftwerken über die Hochspannungs-, die Mittelspannungs- und die Niederspannungsnetze bis hin zu den einzelnen Verbrauchern floss. Dies hatte zur Folge, dass die Netzbetreiber im Wesentlichen darauf achten mussten, dass die Kraftwerke zu jedem Zeitpunkt des Tages eine dem Durchschnittsverbrauch entsprechende Energiemenge zur Verfügung stellen mussten.

Doch aufgrund des Einsatzes von erneuerbaren Energien, allen voran von volatilen Energiequellen wie Windkraft- und Solarkraftanlagen, wird die Energieerzeugung zunehmend dezentraler und volatiler. Ca. 95% der Einspeisung aus regenerativer Erzeugung erfolgen in Deutschland und in die Nieder- und Mittelspannungsnetze. Dies hat zur Folge, dass zu bestimmten Zeitpunkten an bestimmten Orten innerhalb der Mittel- und Niederspannungsnetze Stromspitzen entstehen. Für diese Stromspitzen stehen jedoch nur begrenzt Speichermöglichkeiten zur Verfügung. Allerdings ist die Speicherung elektrischer Energie grundsätzlich recht unwirtschaftlich und daher lediglich in Ausnahmefällen sinnvoll.

Alternativ zur Speicherung elektrischer Energie bietet sich der konventionelle Netzausbau an, bei welchem die Leitungen, Transformatoren und Schaltwerke entsprechend größer dimensioniert werden. Dies ermöglicht eine Weiterleitung der Stromspitzen auch über größere Strecken, so dass sich die Effekte der häufig lokal zentrierten Stromspitzen landesweit wenigstens zum Teil ausmitteln können. Allerdings ist der konventionelle Ausbau von Spannungsnetzen sehr kostspielig.

Demgegenüber liegt der Erfindung das technische Problem zugrunde, eine Vorrichtung der eingangs genannten Art anzugeben, bei der die vorstehend beschriebenen Nachteile vermieden werden. Zur Lösung dieses technischen Problems lehrt die Erfindung eine Einbauvorrichtung zum Einbau in standardisierten Schaltgerüsten in Kabelverteilstationen von Spannungsnetzen, insbesondere von Niederspannungsnetzen, umfassend ein Reiterunterteil sowie Teilkomponenten, wobei das Reiterunterteil für die elektrische und mechanische Verbindung mit Sammelschienen von Kabelverteilstationen standardisiert ist, wobei als Teilkomponenten eine Kommunikationseinheit und wenigstens ein Sensor vorgesehen sind, wobei die Einbauvorrichtung ein internes, adaptives Datennetz aufweist.

Der Begriff "Schaltgerüst" meint rahmenartige Vorrichtungen, welche in den Kabelverteilstationen angeordnet sind. Die Schaltgerüste weisen Einbauplätze auf, in welche die Einbauvorrichtungen eingesetzt werden können. Der Einfachheit halber hat sich ein herstellerübergreifender Standard hinsichtlich der Abmessungen von Einbauvorrichtungen und Schaltgerüsten entwickelt.

Der Ausdruck "Kabelverteilstation" ist funktional zu verstehen und meint lediglich Knotenpunkte, an denen sich das Spannungsnetz verzweigt. Solche Knotenpunkte können Kabelverteilerschränke an Straßenrändern oder in Ortsnetzstationen sein oder auch Schaltschränke in industriellen Anlagen bzw. auch in Energieverteilungsanlagen.

Das Wort "Reiterunterteil" bezeichnet ein Element, welches mittels Sammelschienenadapter auf Sammelschienen von Kabelverteilstationen aufgehängt wird. Die Sammelschienen sind fest montierte Flachstangen, welche zueinander parallel und waagerecht verlaufen. Die Mittenabstände der Sammelschienen sind normiert und betragen gemäß IEC 60269 100 bzw. 185 mm. Darüber hinaus gibt es noch Werknormen, welche Sammelschienen mit Mittenabständen von 60 mm vorsehen. Die Sammelschienenadapter sind bevorzugt winkelförmig und haken sich in die waagerecht verlaufenden Sammelschienen ein, wodurch gleichzeitig eine elektrische und mechanische Verbindung hergestellt wird.

Der Ausdruck "standardisiert" meint sowohl nationale, als auch internationale Normen wie etwa DIN-Normen, EN-Normen oder auch ISO-Normen. Darunter fallen aber auch herstellerübergreifende Standards, welche sich im Laufe der Zeit etabliert haben und nicht oder noch nicht in DIN-, EN- oder ISO-Normen eingeflossen sind. Insbesondere sind hier die Baubreiten der Reiterunterteile gemeint, welche zwar nicht nach DIN-, EN- oder ISO-Normen bestimmt sind, aber herstellerübergreifend eine Baubreite von 50 mm (Sicherungsgröße NH00) bzw. von 100 mm (Sicherungsgrößen NH1 bis NH3) aufweisen. Dabei sind die Sicherungsgrößen NH00 bis NH03 den Stromstärken 160, 250, 400 bzw. 630 A zugeordnet. Die Bauhöhen der Reiterunterteile variieren zwar, doch auch hier haben sich einige Abmessungen etabliert. Dies sind beispielsweise 400 mm für die Sicherungsgröße NH00 oder 740 mm für die Sicherungsgrößen NH1 bis NH3.

Häufig sind die Einbauvorrichtungen in Schaltgerüste integriert, so dass die Schaltgerüste die Einbauvorrichtungen einzeln oder auch im Ganzen umrahmen. Im Falle von einzelnen Umrahmungen müssen die Einbauvorrichtungen somit von ihren Abmessungen hinsichtlich Baubreite und Bauhöhe kleiner oder gleich der standardisierten Maße sein. Damit bedeutet der Ausdruck "standardisiert" wenigstens, dass das erfindungsgemäße Reitunterteil Maße aufweist, welche kleiner oder, besonders bevorzugt, gleich der oben jeweilig erwähnten Maße der Standards sind.

Der Begriff "Sensoren" meint Bauelemente, welche einen oder mehrere unterschiedliche Parameter erfassen. Die Parameter können sein Stromstärke und/oder Spannung, aber auch Temperatur. Insbesondere bei Messungen von Stromstärke bzw. Spannung können die Sensoren bloße elektrische Leitungen sein. Allerdings können die Sensoren auch komplexere Bauelemente sein, welche beispielsweise die Aufgaben der Messung der Spannungsqualität oder der Stromzählung übernehmen. Mithin können unter den Sensoren Begriffe wie *Power Quality Interface* bzw. *Smart Meter* verstanden werden. Somit können die einzelnen Sensoren eigene Recheneinheiten aufweisen. Die Sensoren können aber auch über eine gemeinsame Recheneinheit miteinander verbunden sein. Die Recheneinheit bzw. die Recheneinheiten dienen vorzugsweise der Verarbeitung der gewonnenen Messwerte. Die Recheneinheit bzw. die Recheneinheiten können einen Datenfilter darstellen, welcher die Messwertdaten, beispielsweise in arithmetisch gemittelter Form, bündelt. Die Recheneinheit bzw. die Recheneinheiten können die analogen Werte in digitale Werte umwandeln und/oder mit einem Zeitstempel versehen. Die Recheneinheit bzw. Recheneinheiten können aus den jeweiligen Parametern, beispielsweise Momentanstromstärke und Momentanspannung, weitere Werte errechnen, wie etwa Frequenzen und Leistungsfaktoren.

Die Sensoren können vor oder nach dem Knotenpunkt in Kabelverteilerstationen angeordnet sein. Die Sensoren können an beliebigen Stellen in der jeweiligen Kabelverteilstation angeordnet sein. Insbesondere bieten sich an die Sammelschienen, die Kabel zur und von der Kabelverteilstation, die Sammelschienenadapter sowie Plätze in oder an den Sicherungslastschaltleisten selber.

Aufgenommene Daten des Sensors bzw. der Sensoren werden dann einer Kommunikationseinheit übergeben, welche vorteilhafterweise zyklisch, beispielsweise minütlich oder stündlich, die Daten an eine zentral und/oder dezentral übergeordnete Leitstelle überträgt. Als Übertragungsart kommen alle gebräuchlichen Kommunikationstechnologien in Betracht *(Broadband over PowerLine Communication* (BPL) bzw. *PowerLine Communication* (PLC) bzw. *PowerLAN,* Funk, *RF-Mesh,* Satellitenfunk, Lichtwellenleiter, *Global System for Mobile Communication* (GSM), *Long Term Evolution* (LTE), Tetrafunk, *Digital Subscriber Line* (DSL), *Universal Mobile Telecommunications System* (UMTS), etc.). Bevorzugt werden das Kommunikationsprotokoll IP und übliche *Smart-Grid*-Schutzprofile verwendet. Im Falle von *PowerLine Communication* werden die Informationen über die Spannungsnetze direkt geleitet. Insbesondere kommt auch eine Kombination aus Funk und *PowerLine Communication* in Frage. Beispielsweise können Kabelverteilerschränke und Ortsnetzstationen mittels *PowerLine Communication* kommunizieren, wohingegen die Ortsnetzstationen mit der übergeordneten Leitstelle per Funk die Daten austauschen. Hier sind weitere Kombinationen der eingangs genannten Kommunikationstechnologien möglich.

Der Ausdruck "Datennetz" meint, dass die Teilkomponenten der Einbauvorrichtungen über das Datennetz zur Kommunikation miteinander verbunden werden. Das Datennetz ist intern und damit auf die Kommunikation von den Teilkomponenten innerhalb der Einbauvorrichtung in der Kabelverteilstation beschränkt. Das Datennetz ist auch adaptiv, so dass jederzeit weitere Teilkomponenten das Datennetz innerhalb der Kabelverteilstation erweitern können. Insbesondere ist das Datennetz in dem Sinne adaptiv, dass es durch bloßes körperliches Hinzufügen von weiteren Teilkomponenten automatisch erweitert wird. Vorzugsweise ist adaptiv im Sinne von *Plug* & *Play* zu verstehen. Besonders vorzugsweise ist das Datennetz in dem Sinne adaptiv, dass ein Initialisierungs- bzw. Installationsschritt auf der Softwareebene vermieden wird.

Das Datennetz kann ein Datenbus oder auch ein kabelloses Netz sein. Der Datenbus wird vorzugsweise durch bloßes Einstecken von entsprechenden Steckern der Teilkomponenten erweitert. Bevorzugt ist der Datenbus in dem Reiterunterteil integriert und bietet Steckplätze über dem Reiterunterteil verteilt an, so dass durch bloßes Einstecken entsprechend kurzer Kabel der Teilkomponenten das Datennetz automatisch erweitert wird. Vorteilhafterweise entspricht der Datenbus einem Flachbandkabel mit Schneidklemmen. Bevorzugt ist die Einbauvorrichtung auch auf zwei oder mehr Reiterunterteile ausdehnbar. Dementsprechend ist auch das Datennetz auf zwei oder mehr Reiterunterteile ausdehnbar. Als kabellose Netze kommen beispielsweise Bluetooth oder auch WLAN, ZigBee oder ähnliches in Frage. Gemäß einer Ausführungsform nutzt das Datennetz *PowerLine Communication,* also die Kommunikation über Stromleitungen mittels der Netzwerkprotokollsprache IP. Bevorzugt finden auch hier die üblichen Datenkommunikationsprotokolle sowie Sicherungsprotokolle Anwendung.

Es liegt im Rahmen der Erfindung, dass das Reiterunterteil eine vormontierte Aufnahme zum modularen Aufnehmen von Teilkomponenten umfasst. Dabei bedeutet "vormontiert", dass die Aufnahme ab Werk auf dem Reiterunterteil befestigt ist, so dass eine Verbindung von Aufnahme und Reiterunterteil vor Ort, also an der Kabelverteilstation, entfällt. Bevorzugt ist die Aufnahme eine Hutschiene, welche besonders bevorzugt der Norm DIN EN 60715 entspricht. Weiter bevorzugt weist die Hutschiene Kantenlängen von 35 x 7,5 mm auf, wie sie in der Norm DIN EN 60715 beschrieben sind. Der Ausdruck "modulares Aufnehmen" meint, dass die Teilkomponenten besonders einfach an der Aufnahme befestigt und auch wieder entfernt werden können. Insbesondere können die Teilkomponenten durch bloßes Einrasten an der Aufnahme befestigt werden.

Vorzugsweise ist als Teilkomponente ein Spannungswandler vorgesehen. Der Spannungswandler wandelt die Spannung von einer oder mehrerer der Sammelschienen in eine Betriebsspannung für die Teilkomponenten um, so dass diese entsprechend versorgt werden. Der Spannungswandler kann ein Einlegewandler sein, welcher im Bereich der Sammelschienenadapter angeordnet wird. Der Spannungswandler kann auch ein Blockwandler sein, welcher die Spannungen aller drei Phasen, beispielsweise am Fuß des Reiterunterteils, umwandelt.

Bevorzugt ist als Teilkomponente eine unterbrechungsfreie Stromversorgung vorgesehen. Die unterbrechungsfreie Stromversorgung dient der Versorgung der Teilkomponenten im Falle eines Stromausfalls, wodurch der Leitstelle besonders wichtige Informationen während des Stromausfalls übermittelt werden können. Vorzugsweise umfasst die Stromversorgung einen Akkumulator, einen Transformator, ein Schaltrelais, eine Logik und einen Kommunikationsanschluss.

Es liegt im Rahmen der Erfindung, dass als Teilkomponente eine Überstromschutzeinrichtung vorgesehen ist. Die Überstromschutzeinrichtung dient der Sicherung der Teilkomponenten vor zu hohen Strömen. Die Überstromschutzeinrichtung kann als Schmelzsicherung oder als Leitungsschutzschalter ausgebildet sein. Weiter vorzugsweise ist die Überstromschutzeinrichtung schaltbar. Gemäß einer besonders bevorzugten Ausführungsform weist die Überstromschutzeinrichtung eine elektronische Sicherungsüberwachung auf, welche im Falle einer Sicherungshandlung der Überstromschutzeinrichtung eine entsprechende Information der Recheneinheit und/oder Leitstelle zukommen lässt. Es liegt im Rahmen der Erfindung, dass als Teilkomponente ein Fehlerstromschutzschalter vorgesehen ist. Der Fehlerstromschutzschalter dient der Sicherung des Fachpersonals vor Fehlerströmen. Der Fehlerstromschutzschalter wird bevorzugt in Kombination mit der Überstromschutzeinrichtung eingesetzt. Vorzugsweise weist der Fehlerstromschutzschalter eine elektronische Sicherungsüberwachung auf. Die elektronische Sicherungsüberwachung sendet im Falle eines Fehlerstroms ein entsprechendes Signal an die Recheneinheit und/oder Kommunikationseinheit und/oder Leitstelle.

Bevorzugt ist als Teilkomponente ein Analog-digital-Wandler vorgesehen. Der Analog-digital-Wandler wandelt analoge Werte der Sensoren in digitale Werte um. Die digitalen Werte können der Recheneinheit bzw. der Kommunikationseinheit zur Verfügung gestellt werden. Der Analog-digital-Wandler ist insbesondere ein *Inline*-*Controller*.

Zweckmäßigerweise ist als Teilkomponente eine Stromzählerschnittstelle vorgesehen. Dabei umfasst der Begriff "Stromzähler" insbesondere auch sogenannte *Smart-Meter.* Die Stromzählerschnittstelle ist mit einen oder mehreren entsprechenden Stromzählern verbindbar. Die Stromzähler sind zweckmäßigerweise in der Kabelverteilstation angeordnet. Vorteilhafterweise sind die Stromzähler mit den von der Kabelverteilstation wegführenden Kabeln verbunden. Von den Kabelverteilstationen wegführende Kabel sind diejenigen Kabel, welche das Spannungsnetz weiter verzweigen. Gemäß einer bevorzugten Ausführungsform befinden sich die Stromzähler unterhalb der Sicherungslastschaltleisten. Vorteilhafterweise sind die Stromzähler mit Straßenkabeln verbunden.

Vorteilhafterweise ist als Teilkomponente ein Aktor vorgesehen. Der Aktor ist ein Element, welches Einspeiser und/oder Verbraucher ansteuert. Vorzugsweise ist der Aktor ein Koppelrelais, mit welchem beispielsweise Wechselrichter von Photovoltaikanlagen an das Spannungsnetz angeschlossen bzw. von diesem getrennt werden können. Bevorzugt ist der Aktor eine ansteuerbare Ladeschnittstelle, beispielsweise für Elektromobile. Die Aktoren sind Ausgabeelemente, über welche die Leitstelle bzw. die Einbauvorrichtung Einfluss nehmen kann auf das lokale Stromangebot bzw. auf die lokale Stromnachfrage.

Vorzugsweise weist die Kommunikationseinheit eine IP-Adresse auf. Dadurch ist die Kommunikationseinheit gemäß des international sehr gängigen IP-Standards ansprechbar. Besonders vorzugsweise ist die Kommunikationseinheit zur Kommunikation mit der Leitstelle IPsec-fähig bzw. beherrscht übliche und geforderte Schutzprofile, wodurch ein gewisses Maß an informationstechnischer Sicherheit erreicht wird. Bevorzugt ist die Kommunikationseinheit eine Netzwerkweiche in Form eines Hubs/Modems/Switches. Weiter bevorzugt weisen eine oder mehrere der Teilkomponenten IP-Adressen auf.

Es liegt im Rahmen der Erfindung, dass der Sensor modular an die Einbauvorrichtung anschließbar ist. Dabei bedeutet der Ausdruck "modular", dass der Sensor besonders einfach an die Einbauvorrichtung anschließbar ist. Insbesondere ist damit gemeint, dass der Sensor lediglich durch ein bloßes Einstecken mit der Einbauvorrichtung verbunden wird und dass dann keine weiteren Initialisierungs- bzw. Installationsschritte notwendig sind. Bevorzugt sind der Sensor und die Einbauvorrichtung *Plug&Play*-fähig. Gemäß einer anderen Ausführungsform können die Sensoren auch kabellos an die Einbauvorrichtung mittels des adaptiven Datennetzes angebunden werden.

Es ist von Vorteil, dass die Einbauvorrichtung einen Deckel umfasst. Der Deckel schützt die Teilkomponenten vor der Witterung und schließt besonders vorzugsweise die Teilkomponenten luftdicht ab. Der Deckel ist bevorzugt transparent, so dass schon im geschlossenen Zustand mit einem Blick erkannt wird, welche Teilkomponenten an die Einbauvorrichtungen angeschlossen sind. Gemäß einer bevorzugten Ausführungsform weist die Einbauvorrichtung eine elektrische Leitung zur Stromversorgung der Teilkomponenten auf, wobei sich die elektrische Leitung über einen Großteil der Einbauvorrichtung zieht. Vorteilhafterweise ist die elektrische Leitung in das Reiterunterteil integriert und stellt Anschlüsse in Form von normierten Buchsen und/oder Steckern zur Verfügung. Gemäß einer vorteilhaften Ausführungsform weisen die Teilkomponenten Stecker auf, welche bei Einrasten der Teilkomponenten in die vormontierte Aufnahme automatisch mit Buchsen der elektrischen Leitung verbunden werden. Gemäß einer bevorzugten Ausführungsform führt die vormontierte Aufnahme das Erdpotential. Die integrierte elektrische Leitung führt vorteilhafterweise das Potential der Betriebsspannung.

Es liegt im Rahmen der Erfindung, dass die vormontierte Aufnahme Teil des Datennetzes ist. Vorzugsweise kommunizieren die Teilkomponenten mittels *PowerLine Communication* über die vormontierte Aufnahme. Gemäß einer Ausführungsform greifen Adapter die *PowerLine Communication-Modulationen* von der vormonierten Aufnahme ab und stellen die aus den *PowerLine Communication-Modulationen* gewonnenen Daten an standardisierten Anschlüssen der Adapter zur Verfügung. Standardisierte Anschlüsse können beispielsweise USB- oder Ethernet-Anschlüsse sein. Gemäß einer anderen Ausführungsform weisen die Teilkomponenten Adapter auf, welche die *Power-Line Communication-Modulationen* von der vormontierten Aufnahme abgreifen und den Teilkomponenten so zur Verfügung stellen. Auf diese Weise wird ermöglicht, dass die vormontierte Aufnahme gleichzeitig der mechanischen und der informationstechnischen Verbindung der Teilkomponenten mittels bloßem Einrasten dient.

Zur Lösung des technischen Problems lehrt die Erfindung auch ein System zur intelligenten Verteilung von elektrischer Energie, mit wenigstens einer erfindungsgemäßen Einbauvorrichtung und einer Leitstelle. Die Leitstelle empfängt von den Kommunikationseinheiten der Einbauvorrichtungen die Informationen über die Netzzustände an den einzelnen Kabelverteilstationen. Dadurch werden die Netzzustände in verhältnismäßig hoher räumlicher Auflösung erfasst. Insbesondere werden Verletzungen von Spannungsbändern bzw. Überlastströme erkannt, welche gegebenenfalls durch eine entsprechende Steuerung von der Leitstelle und/oder von den einzelnen Einbauvorrichtungen ausgeglichen werden können. Die von der Leitstelle oder von den Leitstellen gesammelten Daten können genutzt werden, um diese mit Wetterdaten, Verkehrsdaten, Tarifmodellen, und dergleichen mehr abzugleichen. Beispielsweise kann die Leitstelle über Auswertung von Wetterdaten für regional begrenzte Gebiete den Endverbrauchern, z.B. über eine sogenannte Stromampel, signalisieren, dass der Stromverbrauch zu erhöhen bzw. zu verringern ist.

Zur Lösung des technischen Problems lehrt die Erfindung auch ein Verfahren zur intelligenten Verteilung von elektrischer Energie, mit wenigstens einer erfindungsgemäßen Einbauvorrichtung, wobei die Einbauvorrichtung in ein Schaltgerüst einer Kabelverteilstation von Spannungsnetzen eingebaut wird, wobei der in die Einbauvorrichtung eingebaute Sensor Messungen vornimmt, wobei die in die Einbauvorrichtung eingebaute Kommunikationseinrichtung die Messwerte einer Leitstelle mitteilt, wobei die Einbauvorrichtung und/oder die Leitstelle die Messwerte beurteilt, wobei anhand der Messwerte die Energieflüsse in den Spannungsnetzen gesteuert werden, so dass Verletzungen von Wertebereichen, beispielsweise Verletzungen von Spannungs- bzw. Überlastströme, vermieden werden.

Der Erfindung liegt die Erkenntnis zugrunde, dass bei der erfindungsgemäßen Einbauvorrichtung, dem erfindungsgemäßen System und dem erfindungsgemäßen Verfahren die Transparenz insbesondere der Mittel- und Niederspannungsnetze erhöht wird und der hierfür erforderliche Aufwand gleichzeitig mittels des Modularitätsprinzips möglichst gering gehalten wird. So ermöglicht die Einbauvorrichtung zunächst einen besonders einfach durchzuführenden Einbau der Einbauvorrichtung in Kabelverteilstationen, weil die Einbauvorrichtung besonders für diesen Einsatzzweck entsprechend dimensioniert ist. Nach Wunsch können verschiedene Teilkomponenten in die Einbauvorrichtung auf besonders einfache Weise integriert und für die jeweiligen Netzgegebenheiten parametriert werden. Gemäß einer bevorzugten Ausführungsform werden die Teilkomponenten lediglich mittels Einrasten an der Einbauvorrichtung befestigt und damit gleichzeitig informationstechnisch mit ihr verbunden, ohne dass es eines weiteren Installationsbedarfes benötigen würde. Aufgrund der einfachen Montage mit geringem Anteil an Verkabelungsarbeiten wird zudem auch die Sicherheit des Fachpersonals verbessert. Schließlich kann die Einbauvorrichtung aufgrund des Modularitätsprinzips jederzeit ohne größeren Aufwand nachgerüstet werden. In der Folge stellt die Erfindung eine preisgünstige Alternative zum konventionellen Netzausbau dar.

Im Folgenden wird die Erfindung anhand einer lediglich ein Ausführungsbeispiel darstellenden Zeichnung näher erläutert. Es zeigen in schematischer Darstellung:
- Fig. 1: ein erfindungsgemäßes System zur Regelung von Mittel- und Niederspannungsnetzen,
- Fig. 2: einen dem Stand der Technik entsprechenden Kabelverteilerschrank des Systems aus Fig. 1,
- Fig. 3: eine erfindungsgemäße Einbauvorrichtung zum Einbauen in den Kabelverteilerschrank aus Fig. 2.

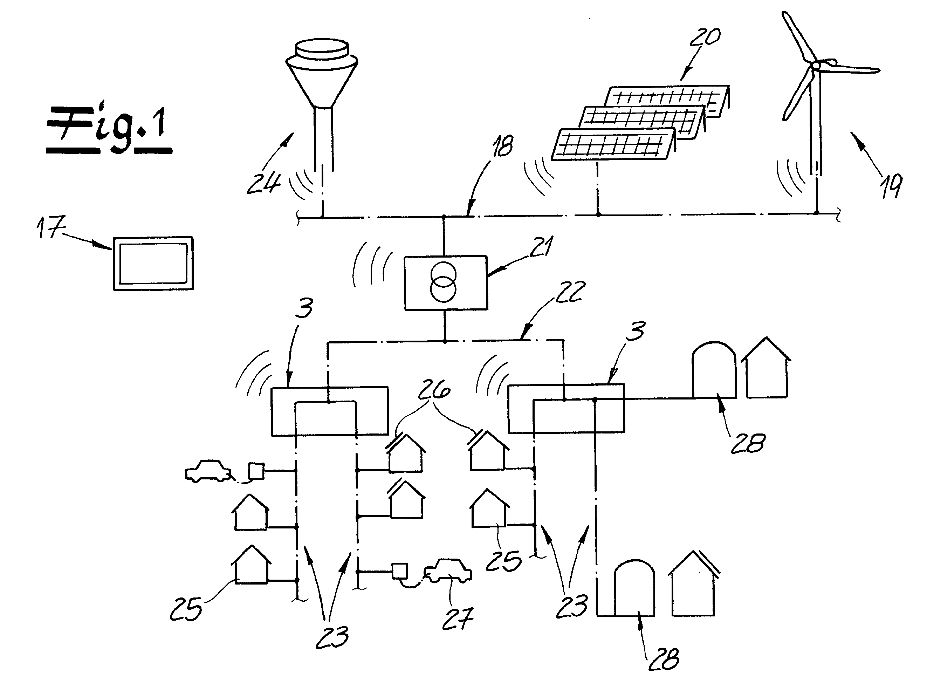

Fig. 1 zeigt ein Mittelspannungsnetz 18 und ein Niederspannungsnetz 22, welche durch eine Ortsnetzstation 21 mit Transformator miteinander verbunden sind. Beide Netze 18, 22 weisen sowohl Einspeiser als auch Verbraucher auf. Im Mittelspannungsnetz 18 finden sich beispielsweise eine Windkraftanlage 19, ein Solarkraftwerk 20 in Form eines Solarparks sowie ein Wasserturm 24, welcher über seine Pumpe als Energiespeicher fungiert.

Das Niederspannungsnetz 22 teilt sich über Kabelverteilerschränke 3 in einzelne Straßennetzkabel 23 auf. Die Straßennetzkabel 23 wiederum umfassen jeweils für sich eine Reihe an reinen Verbrauchern 25, 27 sowie an Verbrauchern 26 mit volatiler Einspeisung. Das Niederspannungsnetz 22 mag auch steuerbare Einspeiser 28 aufweisen, welche zu gut bestimmbaren Zeitpunkten Strom in das Niederspannungsnetz 22 einspeisen können. Ein Beispiel für die steuerbaren Einspeiser 28 sind Biogasanlagen.

Das in Fig. 1 dargestellte erfindungsgemäße System umfasst Kabelverteilerschränke 3, Ortsnetzstationen 21 und größere, volatile Einspeiser 19, 20, welche in der Lage sind, Netzzustände zu erfassen und beispielsweise per Funk - wie symbolisiert - an eine Leitstelle 17 zu übertragen. Auf diese Weise wird das intransparente Niederspannungsnetz 22 und das bestenfalls teiltransparente Mittelspannungsnetz 18 transparenter in dem Sinne, dass die Leitstelle 17 nun Netzzustände in einer höheren räumlichen Auflösung erfassen und verarbeiten kann. Über die Leitstelle 17 werden die volatilen Stromangebote mit den volatilen Stromnachfragen bzw. mit den vorhersehbaren bzw. den steuerbaren Stromnachfragen und Stromangeboten miteinander in Einklang gebracht. Bei sehr starken Stromspitzen im Mittelspannungsnetz 18, etwa an sonnigen und windigen Sonntagen, können beispielsweise Wassertürme 29 mittels Befehl von der Leitstelle 17 die Stromspitzen wenigstens teilweise auffangen und zwischenspeichern.

Nur wenn auch die Netzzustände auf Ebene der einzelnen Straßennetzkabel 23 des Niederspannungsnetzes 22 bekannt sind, können einzelne Stromspitzen noch innerhalb eines Netzes einer Kabelverteilstation 3, 21, also dezentral, ausgeglichen werden. In der Folge werden die Ströme dezentral und intelligent geführt, was in einer Entlastung zentraler Leitungen resultiert. Letztlich ist die intelligente Stromführung damit eine Alternative zum konventionellen Netzausbau mit größer dimensionierten Leitungen und Bauteilen.

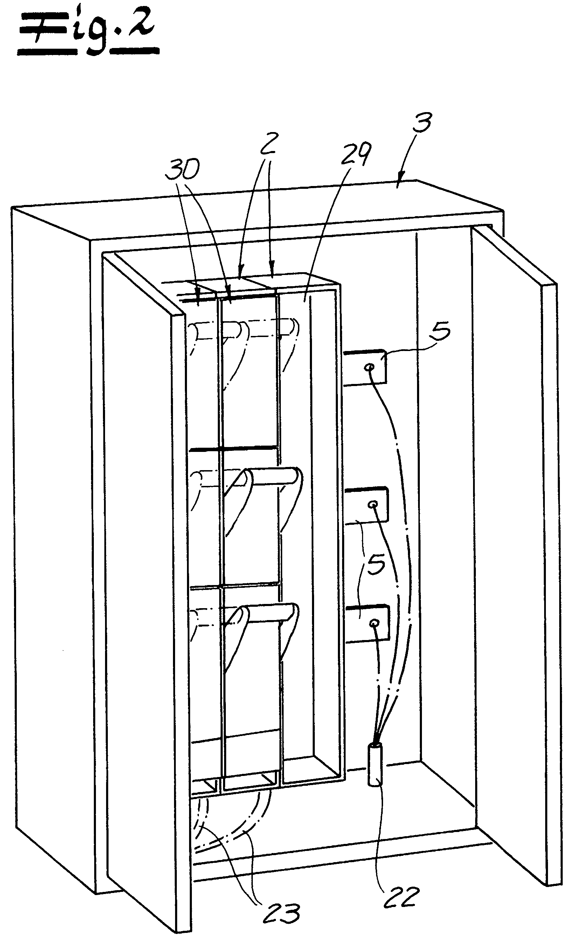

In Fig. 2 ist ein typischer Kabelverteilerschrank 3 gemäß Stand der Technik dargestellt. Ein zur Ortsnetzstation 21 führendes Kabel des Niederspannungsnetzes 22 ist mit drei Sammelschienen 5 verbunden, welche jeweils eine Phase (L1, L2 bzw. L3) führen. Mittels winkelförmigen Sammelschienenadaptern werden Sicherungslastschaltleisten 30 an die Sammelschienen 5 gehängt. Die Sammelschienenadapter stellen neben der mechanischen Verbindung auch die elektrische Verbindung zwischen den Sicherungslastschaltleisten 30 und den Sammelschienen 5 dar. Von jeder Sicherungslastschaltleiste 30 geht ein Kabel 23 ab, welches das jeweilige Straßennetzkabel 23 versorgt. Die Sicherungslastschaltleisten 30 befinden sich in Schaltgerüsten 2, welche die Sicherungslastschaltleisten 30 umrahmen. Das Schaltgerüst 2 weist außerdem einen freien Einbauplatz 29 auf, welcher die üblichen Abmessungen gemäß des herstellerübergreifenden Standards besitzt. Dieser freie Einbauplatz 29 diente bisher als Reserveplatz, welcher aber nun mit der erfindungsgemäßen Einbauvorrichtung 1 belegt wird.

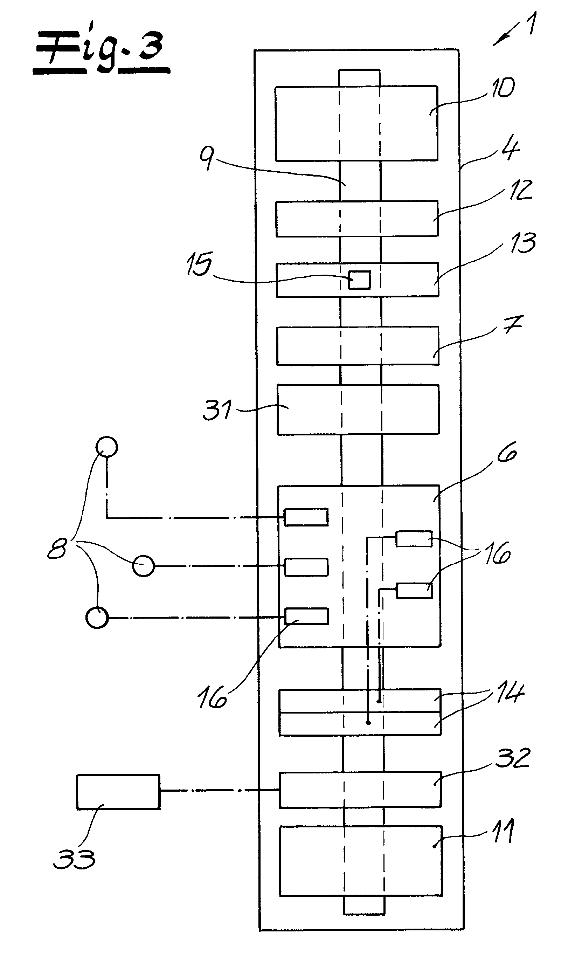

In Fig. 3 ist die erfindungsgemäße Einbauvorrichtung 1 in Vorderansicht und vereinfachender Blockdarstellung gezeichnet. Die Einbauvorrichtung 1 weist zunächst ein Reiterunterteil 4 auf, welches rückseitig angeordnete Sammelschienenadapter umfasst und so ohne weiteres auf die Sammelschienen 5 des Kabelverteilerschrankes 3 gehängt werden kann. Das Reiterunterteil 4 entspricht zudem den herstellerübergreifenden Abmessungsstandards, so dass die Einbauvorrichtung 1 problemlos in den freien Einbauplatz 29 des Schaltgerüsts 2 des Kabelverteilerschrankes 3 eingesetzt werden kann. Eine Hutschiene 9 gemäß DIN EN 60715 mit den Kantenabmaßen 35 x 7,5 mm verläuft entlang der Vorderseite des Reiterunterteils 4, um Teilkomponenten am Reiterunterteil 4 befestigen zu können.

Die Einbauvorrichtung 1 weist ferner eine Recheneinheit 6, eine Kommunikationseinheit 7 sowie einen oder mehrere Sensoren 8 auf. Die Sensoren 8 in Form von elektrischen Leitungen sind beispielsweise an den Kabeln 22, 23, an den Sammelschienen 5 bzw. an den Sicherungslastschaltleisten 30 angeordnet und erfassen Ströme bzw. Spannungen. Die Sensoren 8 sind mit digitalisierenden Messkarten in Steckplätzen 16 der Recheneinheit 6 mit der Einbauvorrichtung 1 verbunden. Die Recheneinheit 6 ist als *Power Quality Interface* ausgebildet und löst zahlreiche Messaufgaben in elektrischen Netzen nach Netzqualitätsnormen. Die Anbindung geschieht über das Kommunikationsprotokoll IEC 61850 und über eine TCP-IP Schnittstelle mit Verbindung zur Kommunikationseinheit 7. Die Daten der Sensoren 8 werden durch die Recheneinheit 6 gefiltert und vorverarbeitet und schließlich mittels eines in das Reiterunterteil 4 integrierten Datenbusses an die Kommunikationseinheit 7 übertragen. Alternativ können die rohen Daten der Sensoren 8 auch von einem Analog-digital-Wandler 31 digitalisiert und dann an die Kommunikationseinheit 7 übergeben werden. Der Datenbus ist adaptiv, kann also jederzeit durch eine bloße Steckverbindung um weitere Teilkomponenten erweitert werden. Dieser Datenbus ist als Flachbandkabel mit Schneidklemmen ausgeführt.

Die Kommunikationseinheit 7 versendet die vorverarbeiteten Daten an die Leitstelle 17. Die Datenübertragung zwischen Kommunikationseinheit 7 und Leitstelle 17 geschieht per Satellitenfunk. Hierzu erhält die Kommunikationseinheit 7 eine IP-Adresse, mittels derer die Leitstelle 17 und die Kommunikationseinheit 7 über das standardisierte Protokoll IPsec miteinander kommunizieren können.

Die Einbauvorrichtung 1 umfasst ferner einen Spannungswandler 10 in Form eines Einlegewandlers. Der Einlegewandler greift die Spannung im Bereich eines Sammelschienenadapters von der entsprechenden Sammelschiene 5 ab und wandelt die Spannung von 230 Volt Wechselspannung, z.B. auf 24 Volt Gleichspannung herunter. Das 24-Volt-Potential dient den an die Einbauvorrichtung 1 angeschlossenen Teilkomponenten als Betriebsspannung. Das Betriebsspannungspotential wird auf einer elektrischen Leitung geführt, welche in dem Reiterunterteil 4 integriert ist.

An der Einbauvorrichtung 1 ist eine unterbrechungsfreie Stromversorgung 11 vorgesehen, welche im Falle eines Stromausfalls den Betrieb der Einbauvorrichtung 1 weiterhin gewährleistet und so wertvolle Informationen gerade während der Ausfallzeit an die Leitstelle 17 übermitteln kann. Die unterbrechungsfreie Stromversorgung 11 ist in bekannter Weise mit einem Akkumulator, einem Transformator, einem Schaltrelais sowie einer entsprechenden Logik ausgestattet.

Zur Absicherung ist an der Einbauvorrichtung 1 zudem eine Überstromschutzeinrichtung 12 angeordnet, welche die Teilkomponenten vor entsprechenden Überströmen schützt. Ein Fehlerstromschutzschalter 13 dient der Sicherung des Fachpersonals, welches die Einbauvorrichtungen 1 installiert und wartet. In den Fehlerstromschutzschalter 13 ist eine elektronische Sicherungsüberwachung 15 integriert, welche unmittelbar nach einer Sicherungshandlung des Fehlerstromschutzschalters 13 aktiviert wird und ein Signal an die Leitstelle 17 sendet. Dadurch wird die Leitstelle bei Störungen in Echtzeit und mit exakter Lokalisierung über die Störung unterrichtet. Zwar ist auch die Kommunikationseinheit 7 in der Lage, Fehler zu melden, doch ist im Falle von Störmeldungen eine Redundanz zweckmäßig. Die elektronische Sicherungsüberwachung 15 wird als potentialfreie Kontaktmeldung ausgeführt. Dieses Signal wird einem Analog-digital-Wandler 31 übergeben. Über die Verbindung der Kommunikationseinheit 7 mit dem Analog-digital-Wandler 31 ist die elektronische Sicherungsüberwachung 15 auch fernauslesbar.

An der Einbauvorrichtung 1 ist weiterhin eine Stromzählerschnittstelle 32 vorgesehen. Die Stromzählerschnittstelle ermöglicht eine Verbindung mit einem Stromzähler 33, welcher den Strom der Straßennetzkabel 23 bzw. den Strom zu Hausanschlüssen zählt.

Die Einbauvorrichtung 1 umfasst schließlich Aktoren 14 in Form von Koppelrelais. Die Koppelrelais trennen die Stromkreise der Sammelschienen 5 galvanisch von denjenigen von beispielsweise Wechselrichtern, welche mit Photovoltaikanlagen der Häuser verbunden sind. Durch Schalten der Koppelrelais können beispielsweise die Photovoltaikanlagen zum Niederspannungsnetz 22 hinzugeschaltet bzw. davon getrennt werden. Die Koppelrelais stellen somit Eingriffsmöglichkeiten dar, um die Stromangebote an die Stromnachfragen anzupassen. Die Koppelrelais werden, wie auch die Sensoren 8, mit der Recheneinheit 6 verbunden. Die Ladeschnittstellen werden mit entsprechenden Steckdosen von Stellplätzen bzw. Garagen verbunden.

## Patentansprüche

1. Einbauvorrichtung (1) zum Einbau in standardisierten Schaltgerüsten (2) in Kabelverteilstationen (3) von Spannungsnetzen (18, 22), insbesondere von Niederspannungsnetzen (22), umfassend ein Reiterunterteil (4) sowie Teilkomponenten, wobei das Reiterunterteil (4) für die elektrische und mechanische Verbindung mit Sammelschienen (5) von Kabelverteilstationen (3) standardisiert ist, wobei als Teilkomponenten eine Kommunikationseinheit (7) und wenigstens ein Sensor (8) vorgesehen sind, **dadurch gekennzeichnet, dass** die Einbauvorrichtung (1) ein internes, adaptives Datennetz aufweist.

2. Einbauvorrichtung (1) nach Anspruch 1, wobei das Reiterunterteil (4) eine vormontierte Aufnahme (9) zum modularen Aufnehmen von Teilkomponenten umfasst.

3. Einbauvorrichtung (1) nach Anspruch 1 oder 2, wobei als Teilkomponente ein Spannungswandler (10) vorgesehen ist.

4. Einbauvorrichtung (1) nach einem der Ansprüche 1 bis 3, wobei als Teilkomponente eine unterbrechungsfreie Stromversorgung (11) vorgesehen ist.

5. Einbauvorrichtung (1) nach einem der Ansprüche 1 bis 4, wobei als Teilkomponente eine Überstromschutzeinrichtung (12) und/oder ein Fehlerstromschutzschalter (13) vorgesehen ist.

6. Einbauvorrichtung (1) nach einem der Ansprüche 1 bis 5, wobei als Teilkomponente ein Analog-digital-Wandler (31) vorgesehen ist.

7. Einbauvorrichtung (1) nach einem der Ansprüche 1 bis 6, wobei als Teilkomponente eine Stromzählerschnittstelle (32) vorgesehen ist.

8. Einbauvorrichtung (1) nach einem der Ansprüche 1 bis 7, wobei als Teilkomponente ein Aktor (14) vorgesehen ist.

9. Einbauvorrichtung (1) nach einem der Ansprüche 1 bis 8, wobei die Kommunikationseinheit (6) eine IP-Adresse aufweist und vorzugsweise IPsecfähig ist.

10. Einbauvorrichtung (1) nach einem der Ansprüche 1 bis9, wobei der Sensor (7), vorzugsweise wenigstens ein weiterer Sensor (8), und besonders vorzugsweise wenigstens ein Aktor (14) modular an die Einbauvorrichtung (1) anschließbar sind.

11. Einbauvorrichtung (1) nach einem der Ansprüche 1 bis 10, wobei die Einbauvorrichtung (1) einen, vorzugsweise transparenten, Deckel umfasst.

12. Einbauvorrichtung (1) nach einem der Ansprüche 1 bis 11, wobei die Einbauvorrichtung (1) eine elektrische Leitung zur Stromversorgung der Teilkomponenten aufweist, wobei sich die elektrische Leitung über einen Großteil der Einbauvorrichtung (1) zieht.

13. Einbauvorrichtung (1) nach einem der Ansprüche 2 bis 12, wobei die vormontierte Aufnahme Teil des Datennetzes ist.

14. System zur intelligenten Verteilung von elektrischer Energie, mit wenigstens einer Einbauvorrichtung (1) nach einem der Ansprüche 1 bis 13 und einer Leitstelle (17).

15. Verfahren zur intelligenten Verteilung von elektrischer Energie, mit wenigstens einer Einbauvorrichtung (1) nach einem der Ansprüche 1 bis 13, wobei die Einbauvorrichtung (1) in ein Schaltgerüst (2) einer Kabelverteilstation (3) von Spannungsnetzen eingebaut wird,
wobei der in die Einbauvorrichtung (1) eingebaute Sensor (8) Messungen vornimmt,
wobei die in die Einbauvorrichtung (1) eingebaute Kommunikationseinrichtung (7) die Messwerte einer Leitstelle (17) mitteilt,
wobei die Einbauvorrichtung (1) und/oder die Leitstelle (17) die Messwerte beurteilt,
wobei anhand der beurteilten Messwerte die Energieflüsse in den Spannungsnetzen gesteuert werden, so dass Verletzungen von Wertebereichen, beispielsweise Verletzungen von Spannungsbändern bzw. Überlastströme, vermieden werden.

## Claims

1. An installation fixture (1) for installation in switch racks (2) in cable distribution stations (3) of voltage networks (18, 22), in particular low-voltage networks (22), comprising a rider base unit (4), and also subcomponents, wherein the rider base unit (4) is standardised for electrical and mechanical connection with bus bars (5) of cable distribution stations (3), wherein a communications unit (7) and at least one sensor (8) are provided as subcomponents, **characterised in that** the installation fixture (1) has an internal adaptive data network.

2. The installation fixture (1) in accordance with claim 1, wherein the rider base unit (4) comprises a pre-installed holding fixture (9) for the modular accommodation of subcomponents.

3. The installation fixture (1) in accordance with claim 1 or 2, wherein a voltage converter (10) is provided as a subcomponent.

4. The installation fixture (1) in accordance with one of the claims 1 to 3, wherein an uninterruptible power supply (11) is provided as a subcomponent.

5. The installation fixture (1) in accordance with one of the claims 1 to 4, wherein an excess current protection unit (12) and/or a fault current circuit breaker (13) are provided as subcomponents.

6. The installation fixture (1) in accordance with one of the claims 1 to 5, wherein an analogue-to-digital converter (31) is provided as a subcomponent.

7. The installation fixture (1) in accordance with one of the claims 1 to 6, wherein an electricity meter interface (32) is provided as a subcomponent.

8. The installation fixture (1) in accordance with one of the claims 1 to 7, wherein an actuator (14) is provided as a subcomponent.

9. The installation fixture (1) in accordance with one of the claims 1 to 8, wherein the communications unit (6) has an IP address and is preferably IPSec-capable.

10. The installation fixture (1) in accordance with one of the claims 1 to 9, wherein the sensor (7), preferably at least one further sensor (8), and particularly preferably at least one actuator (14), can be connected onto the installation fixture (1) in a modular manner.

11. The installation fixture (1) in accordance with one of the claims 1 to 10, wherein the installation fixture (1) comprises a preferably transparent cover.

12. The installation fixture (1) in accordance with one of the claims 1 to 11, wherein the installation fixture (1) has an electrical lead for purposes of supplying power to the subcomponents, wherein the electrical lead runs via a large part of the installation fixture (1).

13. The installation fixture (1) in accordance with one of the claims 2 to 12, wherein the pre-installed holding fixture is part of the data network.

14. A system for the intelligent distribution of electrical power, with at least one installation fixture (1) in accordance with one of the claims 1 to 13, and a control station (17).

15. A method for the intelligent distribution of electrical power, with at least one installation fixture (1) in accordance with one of the claims 1 to 13, wherein the installation fixture (1) is installed in a switch rack (2) of a cable distribution station (3) of voltage networks, wherein
the sensor (8) installed in the installation fixture (1) undertakes measurements, wherein
the communications unit (7) installed in the installation fixture (1) communicates the measured values to a control station (17), wherein
the installation fixture (1) and/or the control station (17) evaluates the measured values, wherein the energy flows in the voltage networks are controlled on the basis of the evaluated measured values, so that violations of value regions, for example, violations of voltage ranges, or excess currents, are avoided.

## Revendications

1. Dispositif à encastrer (1) destiné à être monté dans des ossatures de commutation (2) dans des postes distributeurs de câbles (3) de réseaux électriques (18, 22), notamment de réseaux électriques (22) à basse tension, comprenant une partie inférieure (4) de cavalier, ainsi que des composants partiels, la partie inférieure (4) de cavalier étant standardisée pour être connectée électriquement et mécaniquement avec des barres collectrices (5) de postes distributeurs de câbles (3) en tant que composants partiels étant prévus une unité de communication (7) et au moins un capteur (8), **caractérisé en ce que** le dispositif à encastrer (1) comporte un réseau de données interne, adaptatif.

2. Dispositif à encastrer (1) selon la revendication 1, la partie inférieure (4) de cavalier comprenant un logement (9) prémonté, pour le logement modulaire de composants partiels.

3. Dispositif à encastrer (1) selon la revendication 1 ou la revendication 2, en tant que composant partiel étant prévu un transformateur de tension (10).

4. Dispositif à encastrer (1) selon l'une quelconque des revendications 1 à 3, en tant que composant partiel étant prévue une alimentation électrique (11) sans coupure.

5. Dispositif à encastrer (1) selon l'une quelconque des revendications 1 à 4, en tant que composant partiel étant prévu un système disjoncteur de surintensité (12) et/ou un interrupteur de protection (13) contre les courants de court-circuit.

6. Dispositif à encastrer (1) selon l'une quelconque des revendications 1 à 5, en tant que composant partiel étant prévu un convertisseur analogique/numérique (31).

7. Dispositif à encastrer (1) selon l'une quelconque des revendications 1 à 6, en tant que composant partiel étant prévue une interface (32) pour compteur électrique.

8. Dispositif à encastrer (1) selon l'une quelconque des revendications 1 à 7, en tant que composant partiel étant prévu un actionneur (14).

9. Dispositif à encastrer (1) selon l'une quelconque des revendications 1 à 8, l'unité de communication (6) comportant une adresse IP et étant de préférence apte à l'IPsec.

10. Dispositif à encastrer (1) selon l'une quelconque des revendications 1 à 9, le capteur (7), de préférence au moins un capteur (8) supplémentaire et de matière particulièrement préférée au moins un actionneur (14) pouvant être connectés de manière modulaire sur le dispositif à encastrer (1).

11. Dispositif à encastrer (1) selon l'une quelconque des revendications 1 à 10, le dispositif à encastrer (1) comprenant un couvercle, de préférence transparent.

12. Dispositif à encastrer (1) selon l'une quelconque des revendications 1 à 11, le dispositif à encastrer (1) comportant un conduit électrique pour l'alimentation électrique des composants partiels, le conduit électrique se tirant sur une majeure partie du dispositif à encastrer (1).

13. Dispositif à encastrer (1) selon l'une quelconque des revendications 2 à 12, le logement prémonté étant une partie du réseau de données.

14. Système destiné à la distribution intelligente d'énergie électrique, avec au moins un dispositif à encastrer (1) selon l'une quelconque des revendications 1 à 13 et une centrale de commande (17).

15. Procédé pour la distribution intelligente d'énergie électrique, avec au moins un dispositif (1) selon l'une quelconque des revendications 1 à 13, le dispositif à encastrer (1) étant monté dans une ossature de commutation (2) d'un poste distributeur de câbles (3) de réseaux électriques,
le capteur (8) monté dans le dispositif à encastrer (1) procédant à des mesures,
le système de communication (7) monté dans le dispositif à encastrer (1) communiquant les valeurs mesurées à une centrale de commande (17),
le dispositif à encastrer (1) et/ou la centrale de commande (17) évaluant les valeurs mesurées,
à l'aide des valeurs mesurées évaluées, les flux d'énergie dans les réseaux électriques étant commandés de sorte à éviter des détériorations de zones coûteuses, par exemple des détériorations de bandes de tension, respectivement des surintensités de courant.
